(19) Europäisches Patentamt

European Patent Office

Office européen des brevets

(11) Veröffentlichungsnummer: **0 267 452 B1**

(12) **EUROPÄISCHE PATENTSCHRIFT**

(45) Veröffentlichungstag der Patentschrift: **06.10.93**

(21) Anmeldenummer: **87114988.6**

(22) Anmeldetag: **14.10.87**

(51) Int. Cl.⁵: **H05K 3/26**, H05K 3/00

(54) Verfahren zur Entfernung von Harzverschmutzungen in Bohrlöchern von Leiterplatten.

(30) Priorität: **11.11.86 DE 3638630**

(43) Veröffentlichungstag der Anmeldung:
**18.05.88 Patentblatt 88/20**

(45) Bekanntmachung des Hinweises auf die
Patenterteilung:
**06.10.93 Patentblatt 93/40**

(84) Benannte Vertragsstaaten:
**BE CH DE ES FR GB IT LI LU NL SE**

(56) Entgegenhaltungen:
**EP-A- 0 137 981**
**EP-A- 0 204 609**
**FR-A- 2 514 037**
**US-A- 4 425 380**

**Handbook of Printed Circuit Design, Manufacture, Components and Assembly; G. Leonida, Electrochemical Publications Ltd., 1981, Seiten 446-447**

(73) Patentinhaber: **SCHERING AKTIENGESELL-
SCHAFT Berlin und Bergkamen**
**Müllerstrasse 170/178**
**Postfach 65 03 11**
**D-13303 Berlin(DE)**

(72) Erfinder: **Meyer, Walter**
**Klosterheider Weg 18**
**D-1000 Berlin 28(DE)**
Erfinder: **Grapentin, Hans-Joachim**
**Wundstrasse 17**
**D-1000 Berlin 19(DE)**

**Beschreibung**

Die Erfindung betrifft ein Verfahren zur Entfernung von Verschmutzungen in Bohrlöchern von Leiterplatten unter Anwendung von Oxydationsmitteln, wie Permanganaten in wässriger Lösung, und/oder Aufquellmitteln sowie unter Einsatz einer Ultraschallbehandlung.

Bei der Herstellung von Multilayern ist es notwendig, zur Entfernung von Harzverschmierungen durch den Bohrprozeß hervorgerufen (im allgemein technischen Sprachgebrauch als "Smear" bezeichnet) einen Vorbehandlungsprozeß durchzuführen. Die Entfernung des "Bohrsmears" soll der sicheren Ankontaktierung der leitenden Multilayer-Innenlagen mit der Durchkontaktierung der Bohrlöcher dienen. Die durch die "Smear"-Entfernung durchgeführte Reinigung des Bohrloches von verklebten oder lose anhaftenden Rückständen des Leiterplattenmaterials dient außerdem der besseren Haftung der bei der Durchkontaktierung abgeschiedenen Metallschicht, wichtig vor allem nach der thermischen Belastung, der die Leiterplatte im Lötprozeß ausgesetzt ist.

Es ist bekannt, den Smear-Removal-Prozeß durch Kalium- oder Natriumpermanganatlösungen durchzuführen, wobei in vielen Fällen vor der oxidierenden Behandlung ein Aufquellen in wässrigen Lösungen mit Zusatz der unterschiedlichen Lösungsmittel und/oder Tensiden erfolgt (siehe z.B US-A-4 425 380). Da die Behandlungszeit bei solchen Prozeßschritten sehr lang ist, ist es weiterhin bekannt, solche Prozeßschritte durch den Einsatz von Ultraschall zu beschleunigen. Dabei ergibt sich aber das Problem, daß bei der üblichen Anordnung der Leiterplatten zur Behandlung in einem Korb ein gleichmäßiges Ultraschallfeld nicht aufgebaut werden kann, so daß je nach Anordnung der Platte im Korb ein unterschiedlicher Angriff erfolgt und damit eine gleichmäßige und sichere Entfernung der Bohrrückstände nicht mehr gewährleistet.

Aufgabe der vorliegenden Erfindung ist die Zurverfügungstellung eines Verfahrens, das eine restlose Entfernung von Verschmutzungen in Bohrlöchern ermöglicht.

Die Lösung dieser Aufgabe erfolgt durch den im Patentanspruch 1 definierten Gegenstand.

Eine vorteilhafte Ausführungsform ist im Unteranspruch ausgeführt.

Die wässrigen Permanganat-Lösungen enthalten Natriumin einer Konzentration von 30-65 g/Liter oder Kaliumpermanganat in einer Konzentration von 30-60 g/Liter.

Als Aufquellmittel eignen sich insbesondere Methyl-, Äthylglycol, 1-Methyl-2-pyrroliden, Butylcarbitol, Dimethylformamid allein oder im Gemisch mit und ohne Ethylenglycol und Tensiden in neutralen bis stark alkalischen Medien.

Für die Ultraschallbehandlung lassen sich übliche Ultraschall-Schwinggeräte verwenden.

Die horizontale Führung der Leiterplatten erfolgt in an sich bekannter Weise in Vorrichtungen, wie sie zum Beispiel in der DE- 32 36 545 beschrieben sind.

Das erfindungsgemäße Verfahren ermöglicht in bisher nicht erreicher Weise einen gleichmäßigen Angriff in allen Behandlungsstufen auf die Bohrrückstände, damit eine sichere Ankontaktierung der Multilayer-Innenlagen gewährleistet ist.

Damit verbunden ist eine wesentliche Verbesserung der Bohrlochqualität, da ein partielles Überätzen vermieden wird.

Weitere überraschende Vorteile sind deutlich verbesserte Bohrlochreinigung auch bei sehr kleinem Bohrlochdurchmesser durch geziele Durchströmung der Bohrlöcher und eine erheblich verkürzte Behandlungszeit (0,2 bis 2 Minuten) und dadurch verbesserte Wirtschaftlichkeit in der Nutzung der Anlagen.

Die Durchführung des erfindungsgemäßen Verfahrens erfolgt beispielsweise derart, indem die gebohrten Multilayer in einer Anlage horizontal geführt eine Schwalleinrichtung mit Ultraschall passieren. Es ist dabei möglich, in der ersten Behandlungsstufe die verklebte Oberfläche durch eine "Anquellerlösung" vorzubehandeln, dann erfolgt ebenfalls im kontinuierlichen horizontalen Durchlauf der Spülprozeß, dem sich die oxidierende Behandlung mit Kalium- oder Natriumpermanganat anschließt. Zur Entfernung der Rückstände der Kalium- oder Natriumpermanganatbehandlung wird die gespülte Platte anschließend durch eine ebenfalls geschwallte Behandlungszone geführt, wobei der sich bildende Braunstein reduziert wird. Abschließend wird wieder gespült und die Platte kann dem Preozeß der Durchmetallisierung zugeführt werden.

Das folgende Beispiel dient zur Erläuterung der verfahrensgemäß verwendeten Mittel.

## BEISPIEL 1

Quellung mit     120 ml/l Äthylglycol

        + 80 ml/l Methylglycol      60 - 90° C

        + 90 g/l   NaOH

Spülung

Ätzung mit     60 g/l   $KMnO_4$

        + 30 g/l   NaOH        60 - 90° C

Spülung

Entgiftung mit Hydroxylammoniumchlorid
in salz- oder schwefelsaure    25 - 90° C
Lösung

Spülung

BEISPIEL 2

Quellung mit          120 ml/l 1-Methyl-2-pyrrolidon    RT - 40° C

              +     80 ml/l Methylglycol


              +     90 g/l   NaOH



Spülung

Ätzung mit


                  60 g/l KMnO$_4$
              +   30 g/l NaOH                   60 - 90° C


Spülung
Entgiftung mit Hydroxylammoniumchlorid
              in salz- oder schwefelsaure
              Lösung                            25 - 90° C
Spülung

4

BEISPIEL 3

Quellung mit         120 ml/l Dimethylformamid    RT   - 40° C

              +   80 ml/l Methylglycol

              +   90 g/l   NaOH

Spülung

Ätzung mit          60 g/l   $KMnO_4$

              +   30 g/l   NaOH         60 - 90° C

Spülung

Entgiftung mit Hydroxylammoniumchlorid

           in salz- oder schwefelsaure     25 - 90° C

           Lösung

Spülung

BEISPIEL 4

Quellung mit     120 ml/l Butylcarbitol     RT - 90° C

    +   80 ml/l Methylglycol

    +   90 g/l   NaOH

Spülung

Ätzung mit     60 g/l KMnO$_4$

    +   30 g/l NaOH     60 - 90° C

Spülung

Entgiftung mit Hydroxylammoniumchlorid

    in salz- oder schwefelsaure   25 - 90° C

    Lösung

Spülung

## BEISPIEL 5

Quellung mit     120 ml/l Ethylenglycol

      +     80 ml/l Methylglycol          60 - 90° C

      +     90 g/l   NaOH

Spülung

Ätzung mit     60 g/l $KMnO_4$

      +     30 g/l NaOH          60 - 90° C

Spülung

Entgiftung mit Hydroxylammoniumchlorid

       in salz- oder schwefelsaure        25 - 90° C

       Lösung

Spülung

### BEISPIEL 6

Quellung wie in den Beispielen 1 bis 5 beschrieben, jedoch unter Zusatz von kationen-, anionen oder nichtionogenen Tensiden.

BEISPIEL 7

Quellung mit                120 ml/l Ethylenglycol

                      +   80 ml/l Methylglycol          60 - 90$^{\circ}$ C

                      +   90 g/l   NaOH

Spülung

Ätzung mit                  60 g/l KMnO$_4$              pH etwa 12 - 14

                      +   X g/l NaOH

Spülung

Entgiftung mit Hydroxylammoniumchlorid

                      in salz- oder schwefelsaure       25 - 90$^{\circ}$ C

                      Lösung

Spülung

8

BEISPIEL 8

Quellung mit          120 ml/l Ethylengylcol

              +    80 ml/l Methylglycol          60 - 90° C

              +    90 g/l  NaOH

Spülung

Ätzung mit          60 g/l KMnO$_4$

              +   100 g/l NaOH

Spülung

Entgiftung mit Hydroxylammoniumchlorid

              in salz- oder schwefelsaure          25 - 90° C

              Lösung

Spülung

## BEISPIEL 9

Quellung mit              120 ml/l Ethylenglycol

+      80 ml/l Methylglycol        60 - 90$^\circ$ C

+      90 g/l NaOH

Spülung

Ätzung mit            60 g/l $KMnO_4$

+      30 - 100 g/l KOH

Spülung

Entgiftung mit Hydroxylammoniumchlorid

in salz- oder schwefelsaure     25 - 90$^\circ$ C

Lösung

Spülung

BEISPIEL 10

Quellung mit          120 ml/l    Ethylenglycol

              +    80 ml/l    Methylglycol    60 - 90° C

              +    90 g/l    NaOH

Spülung

Ätzung mit         60 g/l    $KMnO_4$

              +    X g/l    NaOH oder KOH

              +    0,1 g/l    fluoriertes Netzmittel

Spülung

Entgiftung mit Hydroxylammoniumchlorid

              in salz- oder schwefelsaure    25 - 90° C

              Lösung

Spülung

## BEISPIEL 11

Quellung mit      120 ml/l    Ethylenglycol

          +    80 ml/l    Methylglycol      60 - 90$^{\circ}$ C

          +    90 g/l    NaOH

Spülung

Ätzung mit       200 g/l NaMnO$_4$

          +    70 g/l NaOH

Spülung

Entgiftung mit Hydroxylammoniumchlorid

          in salz- oder schwefelsaure     25 - 90$^{\circ}$ C

          Lösung

Spülung

BEISPIEL 12

Quellung mit        120 ml/l     Ethylenglycol

            +      80 ml/l     Methylglycol      60 - 90$^{\circ}$ C

            +      90 g/l     NaOH

Spülung

Ätzung mit         200 g/l     $NaMnO_4$

            +      70 g/l     NaOH

Spülung

Entgiftung mit salzsaurer Zinn(II)-chloridlösung

Spülung

13

## BEISPIEL 13

Quellung mit 120 ml/l Ethylenglycol

+ 80 ml/l Methylglycol 60 - 90$^o$ C

+ 90 g/l NaOH

Spülung

Ätzung mit 200 g/l NaMnO$_4$

+ 70 g/l NaOH

Spülung

Entgiftung mit einer sauren Formaldehydlösung

Spülung

<u>BEISPIEL 14</u>

Quellung mit          120 ml/l    Ethylenglycol

              +      80 ml/l    Methylglycol    60 - 90$^{\circ}$ C

              +      90 g/l     NaOH

Spülung

Ätzung mit          200 g/l     NaMnO$_4$

              +      70 g/l     NaOH

Spülung

Entgiftung mit einer sauren Hydrazinhydratlösung

Spülung

15

## BEISPIEL 15

Quellung mit        120 ml/l      Ethylenglycol

               +      80 ml/l      Methylglycol     60 - 90$^{\circ}$ C

               +      90 g/l      NaOH

Spülung

Ätzung mit        200 g/l      $NaMnO_4$

               +      70 g/l      NaOH

Spülung

Entgiftung mit einer sauren Glyoxallösung

Spülung

BEISPIEL 16

Quellung mit          120 ml/l      Ethylenglycol

+    80 ml/l      Methylglycol    60 - 90$^\circ$ C

+    90 g/l      NaOH

Spülung

Ätzung mit          200 g/l      $NaMnO_4$

+    70 g/l      NaOH

Spülung

Entgiftung mit reduzierenden Dicarbonsäuren und deren Gemische mit und ohne anorganischen Säurezusatz

Spülung

BEISPIEL 17

Quellung mit        120 ml/l      Ethylenglycol

              +      80 ml/l       Methylglycol        60 -90° C

              +      90 g/l        NaOH

Spülung

Ätzung mit           60 g/l        KMnO$_4$

              +      30 g/l        NaOH                60 - 90° C

Spülung

Entgiftung mit Natrioumbisulfitlösung

Spülung          .

18

BEISPIEL 18

Quellung mit          120 ml/l          Ethylenglycol

            +          80 ml/l           Methylglycol        60 -90$^{\circ}$ C

            +          90 g/l            NaOH

Spülung

Ätzung mit            200 g/l            NaMnO$_4$

            +          70 g/l            NaOH

Spülung

Entgiftung mit gleichzeitiger Galsrückätzung durch Zusatz von Ammoniumbifluorid oder eines anderen fluoridhaltigen Zusatzes

Spülung

**Patentansprüche**

1. Verfahren zur Entfernung von Verschmutzungen in Bohrlöchern von Leiterplatten unter Anwendung von Permanganaten in wässriger Lösung und/oder Aufquellmitteln, sowie unter Einsatz einer Ultraschall-Behandlung, wobei die Leiterplatten wahrend der Behandlung in horizontale Lage horizontal geführt und die wässrige Lösung mittels einer unterhalb der Transportbahn und senkrecht zur Transportrichtung angebrachten Düse auf die geführten Leiterplatten geschwallt werden.

**Claims**

1. Method for the removal of dirt from holes drilled in circuit boards using permanganates in aqueous solution and/or swelling agents and treatment with ultrasound, where the circuit boards are kept in a horizontal position and are transported horizontally during treatment, the aqueous solution being projected on to the circuit boards by means of a jet arranged beneath the transport path and perpendicular to the direction of transport.

**Revendications**

1. Procédé pour l'enlèvement de salissures se trouvant dans les trous percés des plaquettes à circuits imprimés, utilisant des permanganates en solution aqueuse et/ou des agents gonflants ainsi qu'un traitement ultrasonique où les plaquettes à circuits imprimés, en position horizontale, sont transportées horizontalement tandis que la solution aqueuse est projetée contre elles au moyen d'une buse placée au-dessous du trajet de transport et perpendiculairement au sens de déplacement.